# FASCICULE DE BREVET EUROPEEN

(11) **EP 4 180 883 B1**
(45) Date de publication et mention de la délivrance du brevet: **30.07.2025**
(21) Numéro de dépôt: 21208584.9
(22) Date de dépôt: 16.11.2021
(51) Int. Cl.: G04G 17/02

(54) **DISPOSITIF ÉLECTRONIQUE COMPRENANT UNE BATTERIE ET UN MODULE DE PROTECTION**
ELEKTRONISCHE VORRICHTUNG MIT EINER BATTERIE UND EINEM SCHUTZMODUL
ELECTRONIC DEVICE INCLUDING A BATTERY AND A PROTECTION MODULE

(43) Date de publication de la demande: 17.05.2023
(73) Titulaire: ETA SA Manufacture Horlogère Suisse, 2540 Grenchen (CH)
(72) Inventeur: BALEON, Stéphane, 2520 La Neuveville (CH)
(74) Mandataire: ICB SA

(56) Documents cités:
- CN-A- 112 255 905
- CN-U- 211 296 765

## Description

### Domaine technique de l'invention

L'invention concerne le domaine des dispositifs électroniques munis de batteries.

### Arrière-plan technologique

Les batteries des dispositifs électroniques, tels des montres ou des téléphones portables, peuvent subir un emballement thermique d'une façon non prédictible, par exemple suite à un choc, des températures extrêmes, voire même des défauts de production. Malgré une production de haute qualité, il est commun d'estimer toujours un risque de un à dix pour un million de faire face à un emballement thermique sur la vie d'une batterie. Malgré l'utilisation de batteries provenant de productions ayant de hauts standards sur le contrôle qualité, il arrive de voir des attaques en justices contre certains fabricants de dispositifs électroniques, par des utilisateurs ayant eu le poignet brulé par un produit défectueux.

Dans cette situation d'emballement thermique, toute l'énergie chimique de la batterie est dégagée en quelques secondes sous forme d'énergie thermique. Par exemple, une batterie Lithium Ion CR2032 de 100mAh peut monter à plus de 100°C en moins d'une minute.

Lorsque le dispositif électronique est en contact avec la peau, par exemple pour des produits horlogers, la température du boitier peut augmenter au-delà du seuil de brûlure et blesser le porteur de la montre.
CN 112 255 905 A décrit un dispositif électronique comprenant un boîtier et un système électronique agencé dans le boîtier, le boîtier étant muni d'un logement pour une batterie permettant d'alimenter le système électronique en énergie, le boîtier comprenant un module de protection endothermique autonome configuré pour se déclencher automatiquement en cas d'emballement thermique de la batterie afin d'absorber la chaleur, le module se déclenchant automatiquement à partir d'une température seuil.

### Résumé de l'invention

L'invention a pour but de remédier aux inconvénients précités, et vise à fournir un dispositif électronique muni d'une batterie, qui protège le porteur du dispositif électronique du risque de brûlure en cas d'emballement thermique de la batterie.

A cette fin, l'invention se rapporte à un dispositif électronique, selon la revendication 1.

Le dispositif électronique est remarquable en ce qu'il comprend un module de protection endothermique autonome configuré pour se déclencher automatiquement en cas d'emballement thermique de la batterie afin d'absorber la chaleur.

Pour les occasions où une batterie dysfonctionne en chauffant très fort, le module de protection se déclenche et absorbe au moins en partie la chaleur produite par la batterie. Ainsi, l'utilisateur du dispositif électronique est protégé contre le risque de brûlure.

Grâce à l'invention, on évite d'avoir recours à des protections thermiques complexes à mettre en œuvre, du point de vue de l'agencement interne dans le dispositif électronique. De plus, le module peut être adapté sur des dispositifs électroniques existants.

Selon une forme de réalisation particulière de l'invention, les deux produits sont séparés par une paroi avant le déclenchement, la paroi étant dégradable au-delà d'une température seuil.

Selon une forme de réalisation particulière de l'invention, la paroi comprend un alliage métallique à faible température de fusion.

Selon une forme de réalisation particulière de l'invention, les deux produits sont agencés dans une enceinte disposée dans le logement.

Selon une forme de réalisation particulière de l'invention, l'enceinte comporte une pluralité de compartiments, chaque compartiment comportant l'un des deux produits.

Selon une forme de réalisation particulière de l'invention, les compartiments comprennent alternativement chaque produit.

Selon une forme de réalisation particulière de l'invention, les compartiments sont fermés par une paroi dégradable au-delà de la température seuil.

Selon une forme de réalisation particulière de l'invention, le premier et le deuxième produit à mélanger sont à choisir parmi les couples suivants :
- nitrate d'ammonium et eau,
- chlorure de potassium et eau,
- carbonate de sodium et acide éthanoïque,
- chlorure de thionyle et sulfate de cobalt heptahydraté,
- cristaux d'hydroxyde de Baryum octohydraté et chlorure d'ammonium sec.

Selon une forme de réalisation particulière de l'invention, la paroi comprend, de préférence en totalité, un matériau à choisir dans la liste suivante : alliage eutectique d'indium-nitrure de Titane, alliage de Plomb-Bismuth-étain de type métal de Rose, alliage de Plomb-Bismuth, alliage eutectique de Bismuth-nitrure de Titane, alliage eutectique de Bismuth-Indium.

Selon une forme de réalisation particulière de l'invention, la paroi comprend, de préférence en totalité, un matériau polymère, par exemple l'acrylonitrile butadiène styrène de type ABS, le polyéthylène basse densité de type PEBD, ou le polychlorure de vinyle de type PVC

Selon une forme de réalisation particulière de l'invention, le module de protection endothermique est agencé dans le boitier.

Selon une forme de réalisation particulière de l'invention, le module de protection endothermique est agencé à l'extérieur du boitier.

Selon une forme de réalisation particulière de l'invention, la paroi comprend, de préférence en totalité, un alliage métallique à faible température de fusion

### Brève description des figures

Les buts, avantages et caractéristiques apparaîtront à la lecture de la description détaillée qui va suivre, en référence aux dessins annexés, où :
- la figure 1 montre une représentation schématique d'un premier mode de réalisation d'une montre électronique munie d'une batterie, et d'un module de protection thermique selon l'invention,
- la figure 2 montre une représentation schématique d'un premier mode de réalisation d'un module de protection thermique avant le déclenchement,
- la figure 3 montre une représentation schématique du premier mode de réalisation du module de protection thermique après le déclenchement, et
- la figure 4 montre une représentation schématique d'un deuxième mode de réalisation d'un module de protection thermique.

### Description détaillée de l'invention

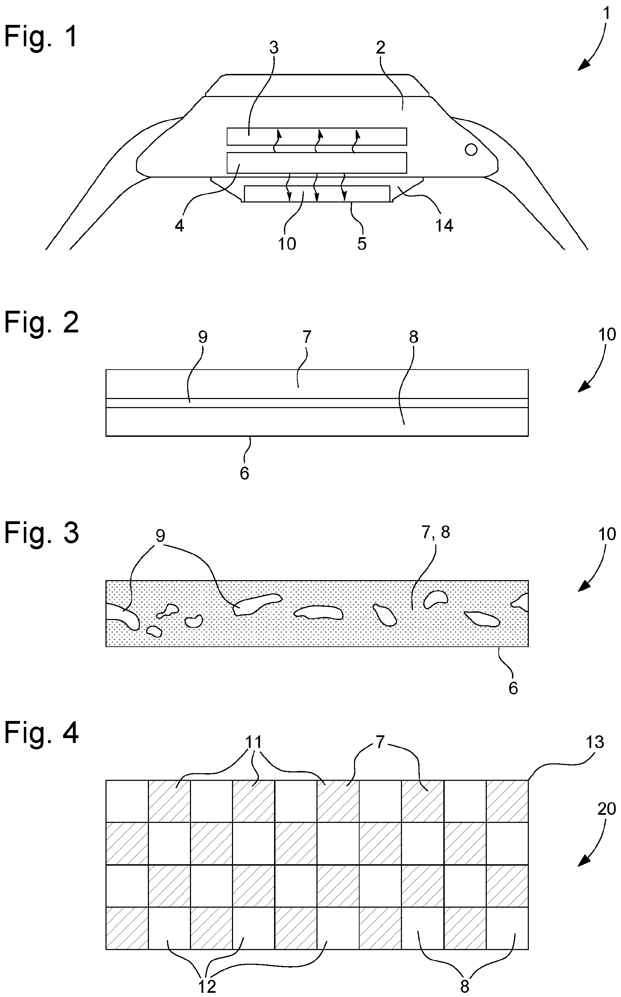

La figure 1 représente un dispositif électronique 1, ici une montre, comprenant un boitier 2, dans lequel est agencé un système électronique 3. Le système électronique 3 comprend, par exemple, un moteur électronique à quartz, et des moyens d'affichage digitaux ou analogiques à aiguilles qui sont commandés par le moteur électronique. Le boitier 2 de la montre comprend un logement 14 pour une batterie 4 permettant d'alimenter le système électronique 3.

Selon l'invention, la montre comprend un module de protection 10 endothermique configuré pour se déclencher en cas d'emballement thermique de la batterie 4 afin absorber la chaleur.

Dans l'exemple de la figure 1, le module de protection 10 est agencé dans le logement entre la batterie 4 et le fond 5 du boitier 2.

D'autres configurations sont possibles, le module de protection étant par exemple agencé à l'extérieur du boitier, contre une paroi correspondant à la position de la batterie à l'intérieur du boitier. Dans le cas d'une montre, le module est disposé entre le fond du boitier et la peau du porteur de la montre. Ainsi, le porteur de la montre est protégé par le module en cas d'emballement.

Dans une autre configuration, le module de protection peut être disposé contre la batterie, à l'opposé de la peau de l'utilisateur pour des raisons d'encombrement. Le flux de chaleur est alors dévié dans la direction opposée de celle de l'utilisateur, limitant la température au contact de la peau.

Le module peut aussi être agencé sur un dispositif électronique déjà existant, par exemple un téléphone portable. Le module est fixé sur la face externe du boitier correspondant à la position de la batterie à l'intérieur du boitier. Différentes sortes de moyens de fixation sont possibles pour attacher le module sur la face du boitier, tels que des vis, une colle résistant aux températures élevées, ou des aimants.

Le module de protection endothermique 10 est configuré pour se déclencher automatiquement à partir d'une température seuil, afin d'absorber au moins en partie la chaleur dégagée par la batterie.

A cette fin, le module 10 comprend deux produits 7, 8, qui sont séparés avant le déclenchement du module 10, et qui sont mélangés lorsqu'il se déclenche. Le mélange des deux produits 7, 8 provoque une réaction chimique endothermique, qui permet d'absorber la chaleur dégagée par la batterie 4.

Les produits 7, 8 se mélangent automatiquement à partir d'une température prédéterminée faisant office de valeur seuil. De préférence, la température de déclenchement est au-delà de 80°C, voire au-delà de 100°C.

Il existe différents types de produits 7, 8 que l'on peut mélanger pour obtenir une réaction endothermique. Cette réaction endothermique permet d'absorber au moins en partie la chaleur dégagée par la batterie. Même si l'énergie n'est absorbée qu'en partie, la température du fond 5 du boitier 2 diminue, de sorte que le porteur de la montre évite une brûlure, et n'a qu'une sensation de forte chaleur.

Pour obtenir une réaction endothermique, le premier produit 7 est par exemple du nitrate d'ammonium et le deuxième produit 8 est de l'eau. Le mélange des deux produits 7, 8 provoque une réaction endothermique.

D'autres couples de produits 7, 8 sont possibles, le premier 7 et le deuxième produit 8 à mélanger étant à choisir parmi les couples suivants :
- chlorure de potassium et eau,
- carbonate de sodium et acide éthanoïque,
- chlorure de thionyle et sulfate de cobalt heptahydraté,
- cristaux d'hydroxyde de Baryum octohydraté et chlorure d'ammonium sec.

Le mélange des produits 7, 8 de chaque couple produit une réaction endothermique, qui absorbe la chaleur dégagée par la batterie.

Sur la figure 2, les deux produits 7, 8 sont agencés dans une enceinte 6 disposée dans le logement 14. Les deux produits 7, 8 sont séparés par une paroi 9 configurée pour éviter le mélange des produits 7, 8. Elle peut par exemple être étanche.

La paroi 9 est dégradable à partir d'une température prédéterminée. Ainsi, en cas d'emballement de la température de la batterie 4, le module 10 se déclenche automatiquement, lorsque la température dégagée par la batterie 4 dépasse la valeur seuil.

La paroi 9 est une membrane qui se désagrège au-delà de ladite température déterminée. La membrane est par exemple un alliage métallique à faible température de fusion, tel qu'un alliage de Bismuth, de type MCP96^{®}, qui a une température de fusion de 100°C. La température de fusion fait office de valeur seuil. Au-delà de la température de fusion, la membrane fond et les deux produits peuvent se mélanger.

D'autres alliages sont possibles, tels qu'un alliage eutectique d'indium-nitrure de Titane, un alliage de Plomb-Bismuth-étain de type métal de Rose, un alliage de Plomb-Bismuth, un alliage eutectique de Bismuth-nitrure de Titane, un alliage eutectique de Bismuth-Indium.

Ces alliages ont une température de fusion différente, 117°C pour l'alliage eutectique d'indium-nitrure de Titane, 95°C pour l'alliage de Plomb-Bismuth-étain de type métal de Rose, 125°C pour l'alliage de Plomb-Bismuth, 138°C pour l'alliage eutectique de Bismuth-nitrure de Titane, 109°C pour l'alliage eutectique de Bismuth-Indium.

Ainsi, en fonction de la protection que l'on souhaite, on choisit un alliage ayant une température de fusion spécifique.

Sur la figure 3, la paroi s'est désagrégée, de sorte que les deux produits 7, 8 se mélange pour produire la réaction endothermique.

La paroi 9 peut aussi comprendre, de préférence en totalité, un matériau polymère, tel que l'acrylonitrile butadiène styrène de type ABS, le polyéthylène basse densité de type PEBD, ou le polychlorure de vinyle de type PVC. L'acrylonitrile butadiène styrène a une température de fusion de 130°C, le polyéthylène basse densité et le polychlorure de vinyle ayant une température de fusion de 100°C.

Dans une variante de réalisation du module 20, représentée sur la figure 4, l'enceinte 13 comporte une pluralité de compartiments 11, 12, chaque compartiment 11, 12 comportant l'un des deux produits 7, 8. Les compartiments 11, 12 sont de plus petite taille que dans le premier mode de réalisation. De préférence, les compartiments 11, 12 comprennent alternativement chaque produit 7, 8.

Chaque compartiment 11, 12 est fermé par une paroi 9 dégradable à une température prédéfinie. Les parois 9 sont du même type que celle de la première variante.

Ainsi, au-delà de la valeur seuil de température, les parois de chaque compartiment se dégradent, de sorte que les deux produits peuvent se mélanger. Grâce à cette configuration, le mélange des produits s'effectue mieux. Le module selon ce mode de réalisation est plus performant, car la réaction entre les produits est très rapide.

D'autres applications sont possibles, en dehors de l'horlogerie, tels les téléphones portables, les ordinateurs portables, ou tout autre objet électronique portable.

## Revendications

1. Dispositif électronique (1), notamment une montre électronique, comprenant un boîtier (2) et un système électronique (3) agencé dans le boîtier (2), le boîtier (2) étant muni d'un logement (14) pour une batterie (5) permettant d'alimenter le système électronique (3) en énergie, le dispositif électronique (1) comprenant un module de protection (10) endothermique autonome configuré pour se déclencher automatiquement en cas d'emballement thermique de la batterie (5) afin d'absorber la chaleur, le module (10) se déclenchant automatiquement à partir d'une température seuil, **caractérisé en ce que** le module de protection (10) comprend deux produits (7, 8) séparés avant le déclenchement, et qui se mélangent après le déclenchement automatique.

2. Dispositif électronique selon la revendication 1, **caractérisé en ce que** les deux produits (7, 8) sont agencés dans une enceinte (6) disposée dans le boitier (2).

3. Dispositif électronique selon la revendication 1 ou 2, **caractérisé en ce que** les deux produits (7, 8) sont séparés par une paroi (9) avant le déclenchement, la paroi (9) étant dégradable au-delà de la température seuil.

4. Dispositif électronique selon la revendication 3, **caractérisé en ce que** l'enceinte (6) comporte une pluralité de compartiments (12, 13), chaque compartiment (12, 13) comportant l'un des deux produits (7, 8).

5. Dispositif électronique selon la revendication 4, **caractérisé en ce que** les compartiments (12, 13) comprennent alternativement chaque produit (7, 8).

6. Dispositif électronique selon la revendication 4 ou 5, **caractérisé en ce que** les compartiments (12, 13) sont fermés par une paroi (9) dégradable au-delà de la température seuil.

7. Dispositif électronique selon l'une, quelconque, des revendications 2 à 6, **caractérisé en ce que** la paroi (9) comprend, de préférence en totalité, un alliage métallique à faible température de fusion.

8. Dispositif électronique selon la revendication 7, **caractérisé en ce que** la paroi (9) comprend, de préférence en totalité, un matériau à choisir dans la liste suivante : un alliage eutectique d'indium-nitrure de Titane, un alliage de Plomb-Bismuth-étain de type métal de Rose, un alliage de Plomb-Bismuth, un alliage eutectique de Bismuth-nitrure de Titane, un alliage eutectique de Bismuth-Indium.

9. Dispositif électronique selon la revendication 6, **caractérisé en ce que** la paroi comprend, de préférence en totalité, un matériau polymère, par exemple l'acrylonitrile butadiène styrène de type ABS, le polyéthylène basse densité de type PEBD, ou le polychlorure de vinyle de type PVC.

10. Dispositif électronique selon l'une, quelconque, des revendications 1 à 6, **caractérisé en ce que** le premier (7) et le deuxième (8) produit à mélanger sont à choisir parmi les couples suivants :
- nitrate d'ammonium et eau,
- chlorure de potassium et eau,
- carbonate de sodium et acide éthanoïque,
- chlorure de thionyle et sulfate de cobalt heptahydraté,
- cristaux d'hydroxyde de Baryum octohydraté et chlorure d'ammonium sec.

11. Dispositif électronique selon l'une, quelconque, des revendications précédentes, **caractérisé en ce que** le module de protection (10) endothermique est agencé dans le boitier (2).

12. Dispositif électronique selon l'une, quelconque, des revendications précédentes, **caractérisé en ce que** le module de protection endothermique est agencé à l'extérieur du boitier.

## Patentansprüche

1. Elektronische Vorrichtung (1), insbesondere eine elektronische Uhr, umfassend ein Gehäuse (2) und ein im Gehäuse (2) angeordnetes elektronisches System (3), wobei das Gehäuse (2) ein Fach (14) für eine Batterie (5) aufweist, die zur Energieversorgung des elektronischen Systems (3) dient, wobei die elektronische Vorrichtung (1) ein autonomes endothermes Schutzmodul (10) umfasst, das so ausgelegt ist, dass es sich bei einem thermischen Durchgehen der Batterie (5) automatisch aktiviert, um Wärme zu absorbieren, wobei sich das Modul (10) ab einer definierten Schwellentemperatur automatisch auslöst, **dadurch gekennzeichnet, dass** das Schutzmodul (10) zwei Stoffe (7, 8) enthält, die vor dem Auslösen getrennt sind und sich nach dem automatischen Auslösen miteinander vermischen.

2. Elektronische Vorrichtung nach Anspruch 1, **dadurch gekennzeichnet, dass** die beiden Stoffe (7, 8) in einer Kammer (6) angeordnet sind, die sich innerhalb des Gehäuses (2) befindet.

3. Elektronische Vorrichtung nach Anspruch 1 oder 2, **dadurch gekennzeichnet, dass** die beiden Stoffe (7, 8) vor der Auslösung durch eine Trennwand (9) getrennt sind, wobei diese Trennwand (9) oberhalb der Schwellentemperatur zerfällt.

4. Elektronische Vorrichtung nach Anspruch 3, **dadurch gekennzeichnet, dass** die Kammer (6) mehrere Fächer (12, 13) aufweist, wobei jedes Fach (12, 13) jeweils einen der beiden Stoffe (7, 8) enthält.

5. Elektronische Vorrichtung nach Anspruch 4, **dadurch gekennzeichnet, dass** die Fächer (12, 13) jeweils abwechselnd eines der Produkte (7, 8) enthalten.

6. Elektronische Vorrichtung nach Anspruch 4 oder 5, **dadurch gekennzeichnet, dass** die Fächer (12, 13) durch eine Trennwand (9) verschlossen sind, die oberhalb der Schwellentemperatur abbaubar ist.

7. Elektronische Vorrichtung nach einem der Ansprüche 2 bis 6, **dadurch gekennzeichnet, dass** die Trennwand (9), vorzugsweise vollständig, aus einer Metalllegierung mit niedriger Schmelztemperatur besteht.

8. Elektronische Vorrichtung nach Anspruch 7, **dadurch gekennzeichnet, dass** die Trennwand (9), vorzugsweise vollständig, aus einem Material besteht, das aus der folgenden Liste ausgewählt ist: eine eutektische Indium-Titan-Nitrid-Legierung, eine Blei-Bismut-Zinn-Legierung vom Typ Rosemetall, eine Blei-Bismut-Legierung, eine eutektische Bismut-Titan-Nitrid-Legierung, eine eutektische Bismut-Indium-Legierung.

9. Elektronische Vorrichtung nach Anspruch 6, **dadurch gekennzeichnet, dass** die Trennwand vorzugsweise vollständig aus einem Polymermaterial besteht, beispielsweise Acrylnitril-Butadien-Styrol (ABS), Polyethylen niedriger Dichte (LDPE) oder Polyvinylchlorid (PVC).

10. Elektronische Vorrichtung nach einem der Ansprüche 1 bis 6, **dadurch gekennzeichnet, dass** das erste (7) und das zweite (8) zu vermischende Produkt aus den folgenden Stoffpaaren ausgewählt sind:
- Ammoniumnitrat und Wasser,
- Kaliumchlorid und Wasser,
- Natriumcarbonat und Essigsäure,
- Thionylchlorid und Cobaltsulfat-Heptahydrat,
- Kristalle von Bariumhydroxid-Octahydrat und trockenem Ammoniumchlorid.

11. Elektronische Vorrichtung nach einem der vorstehenden Ansprüche, **dadurch gekennzeichnet, dass** das endotherme Schutzmodul (10) innerhalb des Gehäuses (2) angeordnet ist.

12. Elektronische Vorrichtung nach einem der vorstehenden Ansprüche, **dadurch gekennzeichnet, dass** das endotherme Schutzmodul außerhalb des Gehäuses angeordnet ist.

## Claims

1. An electronic device (1), in particular an electronic watch, comprising a case (2) and an electronic system (3) arranged within the case (2), the case (2) being provided with a housing (14) for a battery (5) allowing supplying the electronic system (3) with energy, the electronic device (1) comprising a standalone endothermic protection module (10) configured to be automatically triggered in the event of thermal runaway of the battery (5) in order to absorb heat, the module (10) is automatically triggered starting from a threshold temperature, **characterised in that** the protection module (10) comprises two products (7, 8) that are separate before triggering, and which mix together after the automatic triggering.

2. The electronic device according to claim 1, **characterised in that** the two products (7, 8) are arranged within an enclosure (6) disposed in the case (2).

3. The electronic device according to claim 1 or 2, **characterised in that** the two products (7, 8) are separated by a wall (9) before triggering, the wall (9) being degradable beyond the threshold temperature.

4. The electronic device according to claim 3, **characterised in that** the enclosure (6) includes a plurality of compartments (12, 13), each compartment (12, 13) including one of the two products (7, 8).

5. The electronic device according to claim 4, **characterised in that** the compartments (12, 13) alternatively comprise each product (7, 8).

6. The electronic device according to claim 4 or 5, **characterised in that** the compartments (12, 13) are closed by a wall (9) degradable beyond the threshold temperature.

7. The electronic device according to any one of claims 2 to 6, **characterised in that** the wall (9) comprises, preferably in its entirety, a metal alloy with a low melting point.

8. The electronic device according to claim 7, **characterised in that** the wall (9) comprises, preferably in its entirety, a material to be selected from the following list: an indium-Titanium nitride eutectic alloy, a Rose metal type Lead-Bismuth-tin alloy, a Lead-Bismuth alloy, a Bismuth-Titanium nitride eutectic alloy, a Bismuth-Indium eutectic alloy.

9. The electronic device according to claim 6, **characterised in that** the wall comprises, preferably in its entirety, a polymer material, for example ABS-type acrylonitrile butadiene styrene, LDPE-type low-density polyethylene, or PVC-type polyvinyl chloride.

10. The electronic device according to any one of claims 1 to 6, **characterised in that** the first (7) and second (8) products to be mixed are selected from among the following pairs:
- ammonium nitrate and water,
- potassium chloride and water,
- sodium carbonate and ethanoic acid,
- thionyl chloride and cobalt sulphate heptahydrate,
- Barium hydroxide octohydrate crystals and dry ammonium chloride.

11. The electronic device according to any one of the preceding claims, **characterised in that** the endothermic protection module (10) is arranged within the case (2).

12. The electronic device according to any one of the preceding claims, **characterised in that** the endothermic protection module is arranged outside the case.
